# EUROPEAN PATENT SPECIFICATION

(11) **EP 0 834 887 B1**
(45) Date of publication and mention of the grant of the patent: **05.07.2006**
(21) Application number: 97117163.2
(22) Date of filing: 02.10.1997
(51) Int. Cl.: H01C 1/02, H01L 23/28

(54) **Chip component**
Chip-Bauteil
Composant électronique

(30) Priority: 04.10.1996 JP 26467596
(43) Date of publication of application: 08.04.1998
(73) Proprietor: TAIYO YUDEN CO., LTD., Taito-ku Tokyo 110 (JP)
(72) Inventor: Tanaka, Hirotoshi, Taiyo Yuden Co., Ltd., Tokyo, 110 (JP); Kohara, Masataka, Taiyo Yuden Co., Ltd., Tokyo, 110 (JP); Maki, Hideya, Taiyo Yuden Co., Ltd., Tokyo, 110 (JP)
(74) Representative: TER MEER - STEINMEISTER & PARTNER GbR

(56) References cited:
- EP-A- 0 312 046
- PATENT ABSTRACTS OF JAPAN vol. 018, no. 560 (E-1621), 26 October 1994 (1994-10-26) & JP 06 204700 A (MATSUSHITA ELECTRIC IND CO LTD), 22 July 1994 (1994-07-22)
- PATENT ABSTRACTS OF JAPAN vol. 014, no. 018 (E-873), 16 January 1990 (1990-01-16) & JP 01 261887 A (NIPPON CHEMICON CORP), 18 October 1989 (1989-10-18)
- PATENT ABSTRACTS OF JAPAN vol. 018, no. 113 (E-1514), 23 February 1994 (1994-02-23) & JP 05 308665 A (DAIKIN IND LTD), 19 November 1993 (1993-11-19)
- PATENT ABSTRACTS OF JAPAN vol. 018, no. 580 (E-1626), 7 November 1994 (1994-11-07) & JP 06 217309 A (TOKYO UERUZU:KK;OTHERS: 01), 5 August 1994 (1994-08-05)

## Description

### BACKGROUND OF THE INVENTION

### 1.Field of the Invention

The present invention relates to a chip component, such as chip resistor.

### 2. Description of the Prior Art

Among the chip components capable of being fed by means of a chip component feeder such as a bulk feeder, as a chip component allowed to load obversely or reversely on a substrate or the like, the following chip resistor is known.

This chip resistor comprises an insulating ceramics chip having a flat prism shape, a resistor film formed at the center on the front face (one of the two largest-area faces) of a ceramics chip, a pair of lead electrodes formed on both ends in length of front face of the ceramics chip and connected to the ends of the above resistor film, a pair of external electrodes formed on both ends in length of front face of the ceramics chip so as to extend to front face, end faces and back face and connected to the ends of the lead electrodes, and an armor covering an exposed portion of the resistor film.

When said ceramics chip is made of alumina, the resistor film is made of ruthenium oxide and the armor is made of transparent or translucent glass or resin, the color of a portion other than the external electrodes on the back face of component becomes white because the ground color of alumina is white, whereas that of a portion other than the external electrodes on front face of component becomes black because the ground color of ruthenium oxide is black and this color emerges to the surface through the armor.

In other words, because the pair of external electrodes are exposed both on the front face and the back face, said chip resistor can be mounted obversely or reversely to a substrate or the like regardless of the presence or absence of an armor and no particular inconvenience occurs functionally even if packaged reversely. Because of the difference in the color (black) appearing through the armor and the ground color (white) of the ceramics chip, a difference in distribution of lightness occurs between the front face and the back face of component.

A chip component including the chip resistor mentioned above are packaged on a substrate or the like generally through a mounting step, a testing step and a joining step. In the testing step, a testing device (digital image processing device) for detecting the positional deviation or an unmounted component by a color or monochromatic image processing is generally employed and mounted component is subjected to a predetermined test through image pickup, data processing and quality testing steps.

However, since arrangement is difficult in matching the direction of the faces prior to the mounting step, chip component capable of being mounted obversely or reversely to the substrate or the like as with the chip resistor mentioned above might be mounted reversely to the substrate or the like and might end in joining together without being corrected.

As mentioned above, though no particular inconvenience occurs functionally even if the chip component is mounted reversely, but in the case of such chip component as the above-mentioned chip resistor where the lightness distribution is different between the front face and the back face of the chip component, inconveniences that a chip component mounted obversely and a-chip component mounted reversely are identified as different components, a so-called.identification error occurs due to the difference in lightness distribution between the front face and the back face in executing a testing step based on the image processing.

### SUMMARY OF THE INVENTION

The present invention was made in consideration of the above-mentioned circumstances, while a first object thereof relates to chip component such as chip resistor capable of being mounted obversely or reversely to a substrate or the like and is to provide chip component enabling to prevent the identification of chip component mounted obversely and chip component mounted reversely as different ones during a testing step by the image processing.

To achieve the first object, the present invention is defined by the features of independent claim 1 and method claim 4. Thus, the lightness distribution on the front face has similarity with the lightness distribution on the back face of chip component capable of being mounted obversely or reversely to the substrate or the like.

The above and other objects, aspects, features and advantages of the present invention will become apparent from the following detailed description in conjunction with the appended claims.

### BRIEF DESCRIPTION OF THE DRAWINGS

FIGS. 1 (a) and 1 (b) are a top view showing an embodiment of the present invention applied to a chip resistor and a sectional view taken along line b-b thereof;
FIG. 2 to FIG. 9 are drawings showing a method for manufacturing the chip resistor shown in FIG. 1;

### DESCRIPTION OF THE PREFERRED EMBODIMENTS

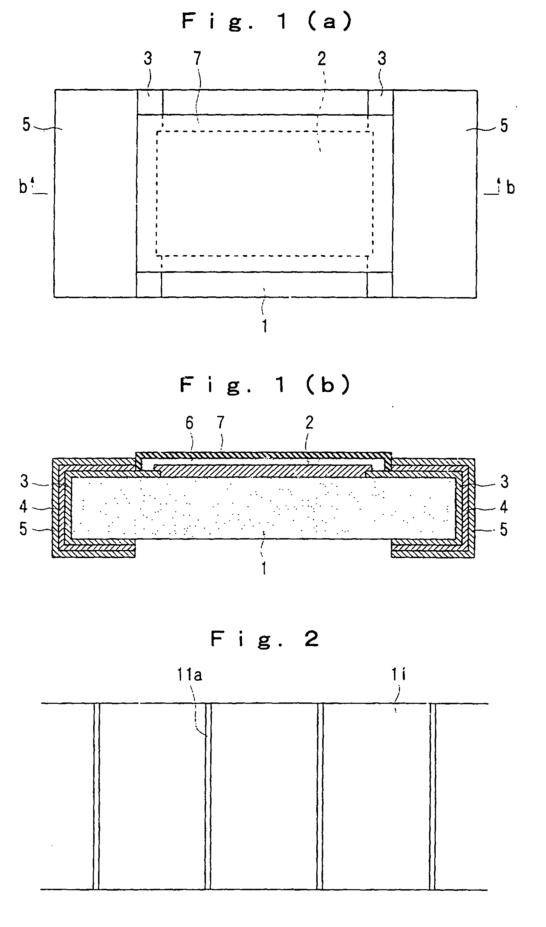

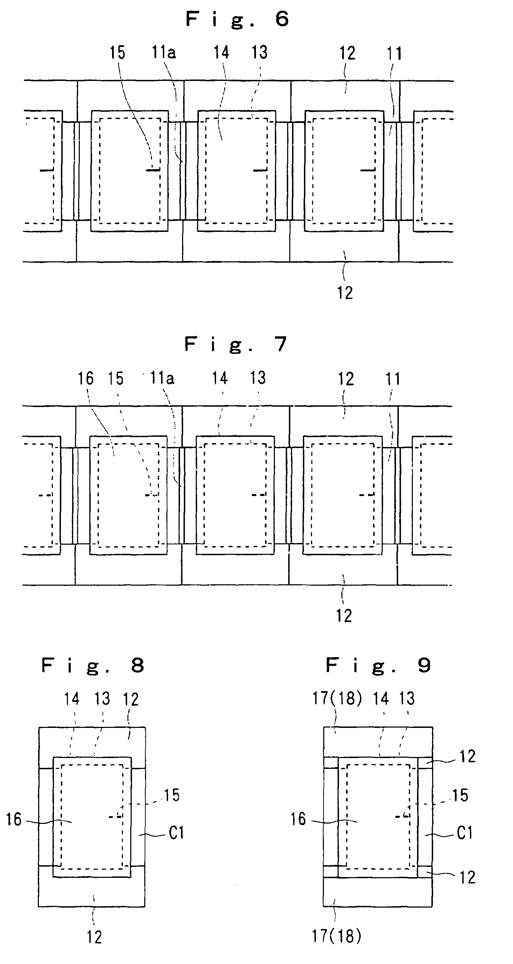

FIGS. 1 and 9 show a preferred embodiment of the present invention applied to a chip resistor.

FIGS. 1 (a) and 1 (b) are a top view of a chip resistor and a sectional view taken along line b-b thereof. As shown in FIG. 1 (a), the chip resistor comprises a ceramics chip 1, a resistor film 2, a pair of lead electrodes 3, a pair of nickel films 4, a pair of solder films 5, a glass film 6 and a resin film 7. In this chip resistor, an armor of two-layer structure is formed of a glass film 6 and a resin film 7 and an external electrode is formed of a nickel film 4 and a solder film 5.

The ceramics chip 1, made of a porcelain composition burned at low temperature (burning temperature: not higher than 1000°C) which contains 25-60 wt% Al₂O₃, 10-40 wt% SiO₂, 3-30 wt% B₂O₃, 1-15 wt% MgO, 0.2-10 wt% Cr₂O₃, 0.1-3 wt% Li₂O and 1-20 wt% of at least one selected from CaO, SrO and BaO, has a high insulating property. This ceramics chip 1 has a shape of a flat prism and has the ground color of green because of containing Cr₂O₃ as a material.

The resistor film 2 is made of ruthenium oxide, and is formed in a rectangular viewed from the above at the center of the front face of the ceramics chip 1 (one of two largest-area faces). The resistor film 2 has the ground color of black because it is made of ruthenium oxide.

The lead electrodes 3, made of silver or its alloy, are so formed as to extend to the front face, the end faces and the back face at both ends in length of the above ceramics chip 1 and connects the respective ends on the front face side to the corresponding ends in length of the resistor film 2.

The nickel films 4, made of nickel or its alloy, are so formed as to cover the above lead electrodes 3.

The solder films 5, made of Sn-Pb alloy, are so formed as to cover the above nickel films 4.

The glass film 6, made of a glass material mainly composed of lead boro-silicate and SiO₂ and containing 50 wt% of the same porcelain composition powder as with the above ceramics chip 1, is so formed as to cover the above resistor film 2. As with the above ceramics chip 1, this glass film 6 has the ground color of green because of containing Cr₂O₃, as a material.

The resin film 7, made of a resin material mainly composed of epoxy resin and containing 50 wt% of the same porcelain composition powder as with the above ceramics chip 1, is so formed as to cover the glass film 6. As with the above ceramics chip 1, this resin film 7 has the ground color of green because of containing Cr₂O₃ as a material.

In other words, by making the same porcelain composition powder as with the above ceramics chip 1 to be contained as coloring matter in a transparent or a translucent glass film 6 and resin film 7, the color of the armor (glass film 6 and resin film 7) is adjusted in such a manner as to become green similar to that of the ceramics chip 1. Accordingly, even if the ground color of the resistor film 2 is black, this color never emerges through the armor.

The above-mentioned chip resistor is so structured that both the resin film 7 constituent of the armor and the ceramics chip 1 are exposed on the portion other than the external electrode of the front face (face on the side of a resistor film) and the ceramics chip 1 is exposed on the portion other than the external electrode of the chip back face (face on the opposite side of a resistor film), but as mentioned above, the color of the front face and that of the ceramics chip 1 are so arranged as to be similar with each other and consequently the component front face and the component back face becomes similar in lightness distribution.

Incidentally, the similarity in lightness distribution here means the inclusion within the tolerance of lightness recognition in the image processing but does not refer to a complete coincidence.

Like a conventional chip component, the chip resistor shown in FIG. 1 is packaged to the substrate or the like through a mounting step, a testing step and a joining step. For the testing step, a testing device (digital image processing device) for detecting the positional deviation or an unmounted component by a color or monochromatic image processing is generally employed and the mounted component is subjected to a predetermined test through image pickup, data processing, quality testing steps.

Meanwhile, since arrangement is difficult in matching the direction of the faces prior to the mounting step, chip component capable of being mounted obversely or reversely to the substrate or the like as with the chip resistor mentioned above might be mounted reversely to the substrate or the like and might end in joining together without being corrected.

With the above chip resistor, however, since the lightness distribution on the front face and the lightness distribution on the back face of the chip component are made similar within the tolerance of lightness recognition in the image processing, there occurs no trouble that chip component mounted obversely and chip component mounted reversely are identified as different components in the testing step of detecting the positional deviation or an unmounted component by a color or monochromatic image processing (digital image processing), even if the component is mounted reversely to the substrate or the like.

Thus, unlike a conventional chip component, a problem of identification error that has been caused by the difference in lightness distribution between the front face and the back face of the chip component can be surely avoided and the testing step can be carried out without a hindrance.

Moreover, since chip component mounted obversely and chip component mounted reversely have a similar color tone, even a mixture of components mounted in opposite directions would bring about no poor appearance.

Furthermore, since powder of the same porcelain composition as the ceramics chip 1 is utilized as coloring matter, no trouble is taken to separately prepare other coloring matters and the color of an armor be equated to that of the ceramics chip by a simple technique.

Hereinafter, referring to FIG. 2 to FIG. 9, a preferable method for manufacturing the chip resistor shown in FIG. 1 will be described.

First, an insulating substrate 11 of a predetermined width is prepared which has parallel separating grooves 11a in length at predetermined intervals as shown in FIG. 2.

This substrate 11 is prepared through a step of mixing Al₂O₃ powder, SiO₂ powder, B₂O₃ power, MgO powder, Cr₂O₃ powder, Li₂O powder, and further at least any one of powder of CaO, SrO and BaO at a predetermined weight ratio and adding a binder and a solvent to this powder mixture to make a slurry, a step of coating the slurry to a predetermined thickness by the doctor blade process to obtain a sheet, a step of forming grooves in the sheet and then cutting the sheet in a direction right-angled thereto to obtain a strip sheet of a predetermined width and a step of burning the strip sheet at 850-1000°C for a predetermined period of time. In addition to a method for forming grooves serving as separating grooves 11a by a technique such as pressing the unburned sheet mentioned above, a forming method by grinding after burning the strip sheet mentioned above may be adopted.

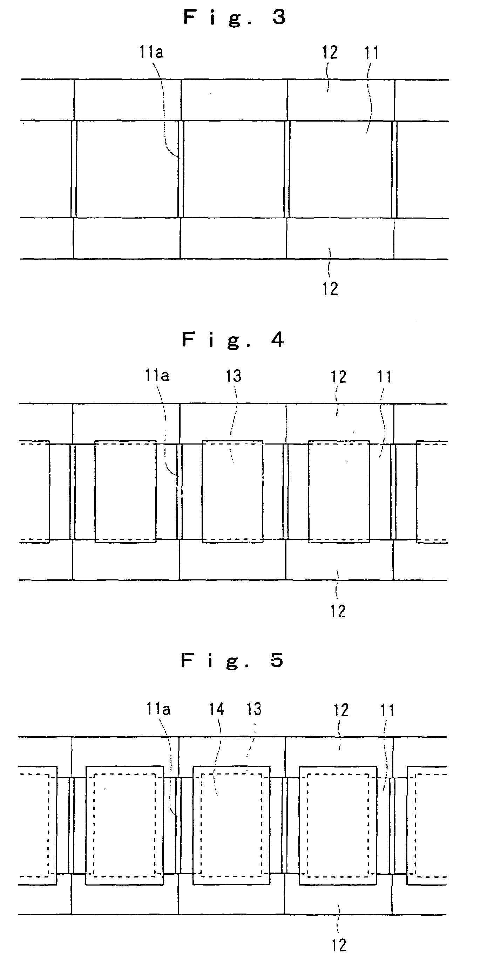

Then, as shown in FIG. 3, a lead electrode 12 is formed along the side edges on both sides in width of the substrate 11. These lead electrodes 12 are formed by coating an electrode paste, prepared by adding a binder and a solvent to powder of silver or its alloy, onto both sides in width of the substrate 11 at a predetermined size and width by a thick-film forming technique such as dip or roller coating, and hardening it by the heating treatment. Needless to say, these lead electrodes 12 can be formed also by using a thin-film forming technique such as evaporation and sputtering while masking the unnecessary portions.

Then, as shown in FIG. 4, a resistor film 13 is formed in each region enclosed by the separating grooves 11a on one face of the substrate 11 in such a manner that both ends overlap on the lead electrodes 12. These resistor films 13 are formed by coating an resistor paste, prepared by adding a binder and a solvent to powder of ruthenium oxide, onto one side at a predetermined position of the substrate 11 in a predetermined shape and thickness by a technique such as screen printing, and hardening it by the heating treatment. Needless to say, these resistor films 13 can be formed also by using the thin-film forming technique such as evaporation and sputtering while masking the unnecessary portions.

Then, as shown in FIG. 5, a glass film 14 is formed on one face of the substrate 11 so as to cover each resistor film 13. These resistor films 14 are formed by coating a glass paste, prepared by adding a binder and a solvent to a powder mixture of powder of lead boro-silicate and SiO₂ with the same porcelain composition powder as with the substrate 11, onto one side at a predetermined position of the substrate 11 in a predetermined shape and thickness by a technique such as screen printing, and hardening it by the heating treatment. Incidentally, the powder of the above porcelain composition can be easily obtained by pulverizing the same material as with the substrate 11.

Then, as shown in FIG. 6, trimming is effected by irradiating a laser beam in the IR region to each resistor film 13 from over the glass film 14 while detecting a value of resistance with a detecting terminal kept in contact with the lead electrodes 12, thus fulfilling the micro-tuning of a value of resistance with a groove 15 formed in each resistor film 13.

Then, as shown in FIG. 7, a resin film 16 is formed on one face of the substrate 11 so as to cover each glass film 14. These resin films 16 are formed by coating a resin paste, prepared by adding the same porcelain composition powder as with the substrate 11 to a fluid of epoxy resin, onto one side at a predetermined position of the substrate 11 in a predetermined shape and thickness by a technique such as screen printing, and hardening it by the heating treatment.

Then, as shown in FIG. 8, the substrate 11 is divided along the separating grooves 11a to prepare unit-shaped ceramics chips Cl.

Then, as shown in FIG. 9, a nickel film 17 and a solder film 18 are formed in succession at both ends in length of the ceramics chip C1. These nickel films 17 and solder films 18 are formed by forming thin films in succession on both sides in length of the ceramics chip Cl through the thin-film forming technique such as non-electrolytic plating or electrolytic plating. Needless to say, these nickel films 17 and solder films 18 can be formed through the thick-film forming technique such as dip or roller coating. By such a procedure, the chip resistor shown in FIG. 1 is manufactured.

According to a method for the chip resistor as shown in FIG. 2 to FIG. 9, the color of the glass film 14 constituent of the armor and that of the resin film 16 can be made green identical with that of the substrate 11 by adding the same porcelain composition powder as with the substrate 11 to the glass paste for the glass film 14 and the resin paste for the resin film 16, respectively.

Besides, since greening of the glass film 14 can elevate the absorptivity of the laser beam, the reflection of the laser beam on the glass film 14 is prevented and an efficient laser trimming can be effected even when the laser trimming to the resistor film 13 is performed via the glass film 14.

Furthermore, since a low-temperature burned substrate that can be burned at 1000°C or lower is employed as the substrate 11, manufacturing of the substrate 11 becomes easy and the manufacturing cost can be reduced.

Meanwhile, in the embodiment shown in FIG. 1 to FIG. 9, component with the armor composed of the glass film and the resin film are exemplified, but both films may be glass or resin and the armor may be a single layer of glass film or resin film if the laser trimming is made directly to the resistor film.

Moreover, a case where the color of both glass and resin film constituent of the armor is made green identical with the ground color of the ceramics chip is exemplified, but the color of the resin film on the front face side alone may be made identical with the ground color of the ceramics chip.

Furthermore, in the embodiment shown in FIG. 1 to FIG. 9, a case where the ground color of the ceramics chip is green is exemplified, but also in a case where the ceramics chip is made of alumina and has a ground color of white and in a case where the ceramics chip has other ground colors than white, a similar effect is obtained if the color of the armor is so adjusted as to match with the relevant ground color.

Still further, in the embodiment shown in FIG. 1 to FIG. 9, a case where the color adjustment is fulfilled by adding the powder of the same material as the ceramics chip or the substrate to a paste for the armor is exemplified, but a similar color adjustment can be made also by adding other coloring matters than the above-mentioned powder to the paste for the armor.

Yet further, in the embodiment shown in FIG. 1 to FIG. 9, a case where the color adjustment is fulfilled by adding the powder of the same material as the ceramics chip or the substrate to the paste for the armor is exemplified, but a similar color adjustment can be made also by coating a paint onto the surface of the armor.

Yet further, in the embodiment shown in FIG. 1 to FIG. 9, component in which the lightness distribution is made similar between the component front face and the component back face is exemplified, but if the hue is identical, no identification error occurs in the testing step based on the color or monochromatic image processing though the saturation differs to some extent, and moreover an outer appearance never deteriorates.

Still further, when the testing device for detecting a positional deviation or unloaded component by the monochromatic image processing, in other words, when the testing device incapable of discriminating the hue is employed in the testing step, it is not always required to match the hue of the armor with that of the ceramics chip, and an identification error can be prevented only by the lightness matching.

Still further, in the embodiment shown in FIG. 1 to FIG. 9, the chip resistor is exemplified as chip component, but if chip component can be mounted obversely or reversely to the substrate or the like, a same effect can be also obtained for any other components than the chip resistor, such as, e.g., chip jumper, chip inductor and chip capacitor.

## Claims

1. A chip component including a ceramic chip (1) made of a porcelain composition, said ceramic chip (1) having a rectangular section, a predetermined length and a predetermined ground color; a resistive film (2) formed on a front face of the ceramic chip (1), said resistive film (2) having a ground color different from the predetermined ground color of the ceramic chip (1); electrode films (3, 4, 5) formed at both ends in length of the ceramic chip (1) so as to conduct both ends in length of the resistive film (2) respectively; and an armor film (6, 7) formed on the front face of the ceramic chip (1) so as to cover the resistive film (2); **characterized in that** the armor film (6, 7) includes a coloring matter which consists of a powder of the same porcelain composition as the ceramic chip (1) and has the same ground color as the ceramic chip (1), thereby a hue distribution of the front face of the chip component and that of the back face of the chip component are approximately the same.

2. The chip component according to Claim 1, wherein the armor film (6, 7) consists of a double layer including a glass film (6) formed so as to cover the resistive film (2) and a resin film (7) formed so as to cover this glass film (6), or a single layer including a glass film (6) or a resin film (7) formed so as to cover the resistive film (2).

3. The chip component according to Claim 1 or Claim 2, wherein the ground color of the ceramic chip (1) and the ground color of the armor film (6, 7) are white.

4. A manufacturing method of a chip component including a step of forming a resistive film (13) on a ceramic chip (11) made of a porcelain composition, said ceramic chip (11) having a rectangular section, a predetermined length and a predetermined ground color, said resistive film (13) having a ground color different from the predetermined ground color of the ceramic chip (11); and a step of forming electrode films (12, 18, 19) at both ends in length of the insulating chip (11) so as to conduct both ends in length of the resistive film (13) respectively; **characterized by** a step of forming an armor film (14, 16) on the front face of the ceramic chip (11) so as to cover the resistive film (13), said armor film (14, 16) including a coloring matter which consists of a powder of the same porcelain composition as the ceramic chip (11) and has the same ground color as the ceramic chip (11), thereby a hue distribution of the front face of the chip component and that of the back face of the chip component are approximately the same.

5. The manufacturing method according to Claim 4, wherein the armor film (14, 16) consists of a double layer including a glass film (14) formed so as to cover the resistive film (13) and a resin film (16) formed so as to cover this glass film (14), or a single layer including a glass film (1.4) or a resin film (16) formed so as to cover the resistive film (13).

6. The manufacturing method according to Claim 4 or Claim 5, wherein the ground color of the ceramic chip (11) and the ground color of the armor film (14, 16) are white.

## Patentansprüche

1. Chip-Bauteil, umfassend: einen keramischen Chip (1) aus einer Porzellanmischung, welcher keramische Chip (1) einen rechteckigen Querschnitt, eine vorbestimmte Länge und eine vorbestimmte Grundfarbe aufweist; eine Widerstandsschicht (2), die auf einer Vorderseite des keramischen Chips (1) angebracht ist, welche Widerstandsschicht (2) eine Grundfarbe aufweist, die von der vorbestimmten Grundfarbe des keramischen Chips (1) verschieden ist; Elektroden-Schichten (3,4,5), die an beiden Enden bezüglich der Länge des keramischen Chips (1) derart angebracht sind, daß beide Enden bezüglich der Länge der Widerstandsschicht (2) jeweils leitend kontaktiert werden; sowie eine Schutzschicht (6,7), die auf der Vorderseite des keramischen Chips (1) derart angebracht ist, daß sie die Widerstandsschicht (2) bedeckt; **dadurch gekennzeichnet, daß** die Schutzschicht (6,7) einen Farbstoff enthält, der aus einem Pulver mit der gleichen Porzellanmischung besteht wie der keramische Chip (1) und welcher die gleiche Grundfarbe wie der keramische Chip (1) aufweist, derart, daß die Farbverteilung auf der Vorderseite des Chip-Bauteils und auf der Rückseite des Chip-Bauteils annähernd gleich ist.

2. Chip-Bauteil gemäß Anspruch 1, bei welchem die Schutzschicht (6,7) aus einer Doppelschicht besteht, einschließlich einer Glasschicht (6), die die Widerstandsschicht (2) bedeckt, und einer Harzschicht (7), die die Glasschicht (6) bedeckt, oder aus einer einzigen Schicht besteht, einschließlich einer Glasschicht (6) oder einer Harzschicht (7), die die Widerstandsschicht (2) bedeckt.

3. Chip-Bauteil gemäß Anspruch 1 oder Anspruch 2, bei welchem die Grundfarbe des Keramik-Chips (1) und die Grundfarbe der Schutzschicht (6,7) Weiß ist.

4. Herstellungsverfahren für ein Chip-Bauteil, umfassend einen Schritt der Bildung einer Widerstandsschicht (13) auf einem keramischen Chip (11) aus einer Porzellanmischung, welcher keramische Chip (11) einen rechteckigen Querschnitt, eine vorbestimmte Länge und eine vorbestimmte Grundfarbe aufweist, welche Widerstandsschicht (13) eine Grundfarbe aufweist, die von der vorbestimmten Grundfarbe des keramischen Chips (11) verschieden ist, und einen Schritt der Bildung von Elektrodenschichten (12.18,19) an beiden Enden bezüglich der Länge des isolierenden Chips (11), derart, daß beide Enden bezüglich der Länge der Widerstandsschicht (13) jeweils leitend kontaktiert werden; **gekennzeichnet durch** einen Schritt der Bildung einer Schutzschicht (14,16) auf der Vorderseite des keramischen Chips (11), so daß die Widerstandsschicht (13) verdeckt wird, welche Schutzschicht (14,16) einen Farbstoff enthält, der aus einem Pulver der gleichen Porzellanmischung besteht wie der keramische Chip (11) und die gleiche Grundfarbe wie der keramische Chip (11) aufweist, derart, daß eine Farbverteilung auf der Vorderseite des Chip-Bauteils und auf der Rückseite des Chip-Bauteils annähernd gleich ist.

5. Herstellungsverfahren gemäß Anspruch 4, bei welchem die Schutzschicht (14, 16) aus einer Doppelschicht besteht, umfassend eine Glasschicht (14), die die Widerstandsschicht (13) bedeckt, und eine Harzschicht (16), die die Glasschicht (14) bedeckt, oder aus einer einzigen Schicht, die eine Glasschicht (14) oder eine Harzschicht (16) umfaßt, die die Widerstandsschicht (13) bedeckt.

6. Herstellungsverfahren gemäß Anspruch 4 oder Anspruch 5, bei welchem die Grundfarbe des keramischen Chips (11) und die Grundfarbe der Schutzschicht (14, 16) Weiß ist.

## Revendications

1. Composant électronique comprenant une puce en céramique (1) constituée d'une composition de porcelaine, ladite puce en céramique (1) ayant une section rectangulaire, une longueur prédéterminée et une couleur de fond prédéterminée ; un film résistif (2) formé sur une face avant de la puce en céramique (1) ledit film résistif (2) ayant une couleur de fond différente de la couleur de fond prédéterminée de la puce en céramique (1) ; des films d'électrode (3, 4, 5) formés aux deux extrémités de la longueur de la puce en céramique (1) de façon à conduire les deux extrémités de la longueur du film résistif (2) respectivement ; et un film armure (6, 7) formé sur la face avant de la puce en céramique (1) de façon à recouvrir le film résistif (2) ; **caractérisé en ce que** le film armure (6, 7) comprend une matière colorante qui consiste en une poudre de la même composition de porcelaine que la puce en céramique (1) et a la même couleur de fond que la puce en céramique (1), moyennant quoi une distribution de teinte de la face avant du composant de puce et celle de la face arrière du composant de puce sont approximativement les mêmes.

2. Composant électronique selon la revendication 1, dans lequel le film armure (6, 7) consiste en une couche double comprenant un film de verre (6) formé de façon à recouvrir le film résistif (2) et un film de résine (7) formé de façon à recouvrir ce film de verre (6), ou une couche unique comprenant un film de verre (6) ou un film de résine (7) formé de façon à recouvrir le film résistif (2).

3. Composant électronique selon la revendication 1 ou la revendication 2, dans lequel la couleur de fond de la puce en céramique (1) et la couleur de fond du film armure (6, 7), sont blanches.

4. Procédé de fabrication d'un composant électronique comprenant une étape consistant à former un film résistif (13) sur une puce en céramique (11) constituée d'une composition de porcelaine, ladite puce en céramique (11) ayant une section rectangulaire, une longueur prédéterminée et une couleur de fond prédéterminée, ledit film résistif (13) ayant une couleur de fond différente de la couleur de fond prédéterminée de la puce en céramique (11) ; et une étape consistant à former des films d'électrode (12, 18, 19) aux deux extrémités de la longueur de la puce isolante (11) de façon à conduire les deux extrémités de la longueur du film résistif (13) respectivement ; **caractérisé par** une étape consistant à former un film armure (14, 16) sur la face avant de la puce en céramique (11) de façon à recouvrir le film résistif (13), ledit film armure (14, 16) comprenant une matière colorante qui consiste en une poudre de la même composition de porcelaine que la puce en céramique (11) et ayant la même couleur de fond que la puce en céramique (11), moyennant quoi une distribution de teinte de la face avant du composant de puce et celle de la face arrière du composant de puce sont approximativement les mêmes.

5. Procédé de fabrication selon la revendication 4, dans lequel le film armure (14, 16) consiste en une couche double comprenant un film de verre (14) formé de façon à recouvrir le film résistif (13) et un film de résine (16) formé de façon à recouvrir ce film de verre (14), ou une couche unique comprenant un film de verre (14) ou un film de résine (16) formé de façon à recouvrir le film résistif (13).

6. Procédé de fabrication selon la revendication 4 ou la revendication 5, dans lequel la couleur de fond de la puce en céramique (11) et la couleur de fond du film armure (14, 16) sont blanches.
